(19) Europäisches Patentamt
European Patent Office
Office européen des brevets

(11) **EP 2 394 774 A2**

(12) **EUROPÄISCHE PATENTANMELDUNG**

(43) Veröffentlichungstag:
**14.12.2011 Patentblatt 2011/50**

(51) Int Cl.:
***B23K 26/00*** *(2006.01)*

(21) Anmeldenummer: **11169098.8**

(22) Anmeldetag: **08.06.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **08.06.2010 DE 102010023568**

(71) Anmelder: **Forschungsverbund Berlin e.V.**
**12489 Berlin (DE)**

(72) Erfinder:
• **Ehrentraut, Lutz**
**15738 Zeuthen (DE)**

• **Rosenfeld, Arkadi**
**10409 Berlin (DE)**
• **Hertel, Ingolf**
**14129 Berlin (DE)**

(74) Vertreter: **Obst, Bernhard**
**Bressel und Partner**
**Patentanwälte**
**Park Kolonnaden**
**Potsdamer Platz 10**
**10785 Berlin (DE)**

(54) **Verfahren und Vorrichtung zum Herstellen nanostrukturierter Oberflächen**

(57) Die Erfindung betrifft eine Vorrichtung (1) und ein Verfahren zum Herstellen nanostrukturierter Oberflächen (4), insbesondere zum Erzeugen von Oberflächen (4) sehr geringer Rauheit über große laterale Ausdehnungen, umfassend die Schritte: Bereitstellen eines Gegenstands (3), welcher eine zu strukturierende Oberfläche (4) aufweist; Erzeugen von Kurzpulslaserstrahlung (15) mit Laserpulsen, deren Pulsdauern im Subnanosekundenbereich, vorzugsweise im Bereich von 100 fs bis 300 fs, liegen, Richten der Kurzpulslaserstrahlung (15) auf die zu strukturierende Oberfläche (4) des Gegenstands (3), so dass eine Fluenz F eines jeden Einzelpulses der Kurzpulslaserstrahlung (15) kleiner als eine Multischuss-Schwellfluenz $F_{th}$ für eine Multischuss-Laserablation ist, jedoch wird die Fluenz F so hoch gewählt, dass über nichtlineare Wechselwirkungen Störstellen erzeugbar sind. Bevorzugt wird eine Fluenz F im Bereich von 65% bis 95% der Multischuss-Schwellfluenz $F_{th}$ für eine Multischuss-Laserablation verwendet.

Fig.1

EP 2 394 774 A2

**Beschreibung**

Die Erfindung betrifft eine Vorrichtung und ein Verfahren zum Herstellen nanostrukturierter Oberflächen, insbesondere zum Erzeugen von Oberflächen mit einer sehr geringen Rauheit über große laterale Ausdehnungen.

Im Bereich der Halbleiterindustrie sowie der Astronomie besteht ein Bedarf, Oberflächen mit sehr hohen Oberflächengüten, insbesondere einer sehr geringen Rauheit, erzeugen zu können. Mit mechanischen Verfahren ist es möglich, Oberflächen so zu polieren, dass diese lokal eine quadratische Rauheit (mittlere quadratische Abweichung) in der Größenordnung von 0,5 bis 1 nm aufweisen. Über lateral ausgedehnte Flächen mit Abmessungen im Bereich von einigen Zentimetern oder Dezimetern treten jedoch Höhenschwankungen bei solchen mechanisch hochpräzise polierten Flächen in der Größenordnung von einigen 10 nm bis 100 nm, in der Regel also Höhenunterschiede im Bereich bis etwa 100 nm auf. Um lateral ausgedehnte ebene Oberflächen mit einer Rauheit erzeugen zu können, wird im Stand der Technik die Oberfläche optisch mit einem interferometrischen Verfahren vermessen, um über die große ausgedehnte laterale Fläche die Höhenschwankungen zu ermitteln. Anschließend wird der Gegenstand mit der zu strukturierenden Oberfläche ins Vakuum verbracht und die Oberfläche mittels Korpuskularstrahlung, insbesondere Elektronenstrahlung, bearbeitet, um Gebiete mit einer größeren Höhe abzutragen.

Die Vermessung der lateralen Höhenunterschiede und eine Strukturierung im Vakuum müssen gegebenenfalls mehrfach iterativ ausgeführt werden, um eine lateral ausgedehnte Fläche mit einer Rauheit oder mittleren quadratischen Rauheit im Bereich von 1 nm zu erhalten. Eine Strukturierung unter Vakuumbedingungen ist sehr aufwendig und sehr zeitintensiv.

Der Erfindung liegt somit die technische Aufgabe zugrunde, ein verbessertes Verfahren und eine verbesserte Vorrichtung zur Herstellung von Oberflächen mit geringer Rauheit, insbesondere zur Erzeugung lateral ausgedehnter Oberflächen mit geringer Rauheit, zu schaffen.

Grundidee der Erfindung

Der Erfindung liegt die Idee zugrunde, die Oberfläche durch Einstrahlung von Kurzpulslaserlicht unter Normaldruckbedingungen zu strukturieren, ohne eine Ablation von Material auszuführen. Hierfür werden über nichtlineare Effekte Störstellen in dem zu strukturierenden Gegenstand erzeugt, was zu einer Kompression des Gegenstands führt. Über eine gezielte lokale Erzeugung von Störstellen kann eine lokale Kompression des Gegenstands und somit eine Strukturierung der Oberfläche des Gegenstands erreicht werden, um dessen Höhenstruktur der Oberfläche zu verändern.

Bevorzugte Ausführungsformen

Insbesondere wird ein Verfahren zum Herstellen nanostrukturierter Oberflächen, insbesondere zum Erzeugen lateral ausgedehnter Oberflächen mit geringer Rauheit, vorgeschlagen, welches die Schritte umfasst: Bereitstellen oder Herstellen eines Gegenstands, welcher eine zu strukturierende Oberfläche aufweist; Erzeugen von Kurzpulslaserstrahlung mit Laserpulsen, deren Pulsdauern im Subnanosekundenbereich liegen, vorzugsweise kürzer als 10 ps sind, am vorteilhaftesten Pulsdauern im Bereich von 0,2 ps aufweisen; Richten der Kurzpulslaserstrahlung auf die zu strukturierende Oberfläche des Gegenstands, so dass eine Fluenz eines jeden Einzelpulses der Kurzpulslaserstrahlung an der Oberfläche des zu bearbeitenden Objekts kleiner als eine Multischuss-Schwellfluenz $F_{th}$ für eine Multischusslaserablation ist. Die Laserpulse werden somit so erzeugt, dass an keiner Stelle über die gesamte Querschnittsfläche der Kurzpulslaserstrahlung eine Ablation stattfindet. Es tritt somit nirgends an der Oberfläche eine Ablation auf. Ferner wird die Fluenz so gewählt, dass keine Coulombexplosion entsteht. Die Energie wird somit immer unterhalb einer Schwelle gewählt, ab der eine Coulombexplosion entstehen kann. Die Kurzpulslaserstrahlung muss so gewählt sein, dass in dem Gegenstand über nichtlineare Prozesse Störstellen erzeugt werden können. Eine Vorrichtung zur Umsetzung dieses Verfahrens umfasst somit einen Kurzpulslaser zum Erzeugen von Kurzpulslaserstrahlung mit Laserpulsen, deren Pulsdauern im Subnanosekundenbereich liegen, vorzugsweise kürzer als 10 ps sind, am günstigsten Pulsdauern im Bereich von 0,2 ps aufweisen, eine Strahlführungseinrichtung zum Führen der Kurzpulslaserstrahlung auf einen Gegenstand sowie eine Halterung zum Aufnehmen des Gegenstands, dessen Oberfläche strukturiert werden soll, wobei der Kurzpulslaser und die Strahlführungseinrichtung so ausgebildet sind, dass eine Fluenz eines jeden Einzelpulses der Kurzpulslaserstrahlung an der Oberfläche des zu bearbeitenden Objekts kleiner als eine Multischuss-Schwellfluenz $F_{th}$ für eine Multischusslaserablation ist. Die Strahlführungseinrichtung umfasst hierbei auch solche Elemente, die eine Strahlformung ausführen und hierüber eine Strahlungsdichte auf der Oberfläche oder in dem Gegenstand, dessen Oberfläche zu strukturieren ist, beeinflussen.

Ein großer Vorteil des Verfahrens und der Vorrichtung liegt darin, dass die Strukturierung bei normalen atmosphärischen Bedingungen ausgeführt werden kann. Das Verfahren kann somit schneller und hierüber kostengünstiger ausgeführt werden.

Die Fluenz wird bei einer bevorzugten Ausführungsform so gewählt, dass diese im Bereich von 50 % bis 99 % der Multischuss-Schwellfluenz $F_{th}$, bevorzugter im Bereich von 65 % bis 95 % der Multischuss-Schwellfluenz $F_{th}$ gewählt wird oder ist. Die Multischuss-Schwellfluenz gibt jene Fluenz an, bei der eine Ablation bei einem mehrfachen Beschuss der Oberfläche des Gegenstands eintritt. Wird die Fluenz geringer als die Multischuss-Schwellfluenz $F_{th}$ gewählt, tritt eine Ablation auch dann nicht ein, wenn beliebig viele Laserpulse auf dieselbe Stelle der Oberfläche des Gegenstands auftreffen. Ferner tritt keine Coulombexplosion auf. Die Fluenz wird somit so gewählt, dass keine Coulombexplosion auftritt. Wird in der Strahlführungseinrichtung eine Linse zur Fokussierung eingesetzt, so kann es erforderlich sein, bei einer kurzbrennweitigen Linse den Fokus ins Innere des Gegenstands zu legen, um eine Plasmabildung vor der zu strukturierenden Oberfläche in der Atmosphäre zu vermeiden. Wird eine langbrennweitige Linse verwendet, so ist es in der Regel möglich, den Fokus auch an die Oberfläche des Gegenstands zu positionieren. Neben einer Strahlformung, wie einer Fokussierung, kann die Fluenz über eine geeignete Wahl von Laserparametern gewählt und gesteuert werden. Insbesondere über eine Steuerung der Leistung des Kurzpulslasers oder/und einer Verstärkung der Kurzpulslaserstrahlung.

Als besonders vorteilhaft hat es sich herausgestellt, die Kurzpulslaserstrahlung mit einer Wellenlänge im infraroten Wellenlängenbereich zu erzeugen. Kurzpulslaser im infraroten Wellenlängenbereich sind kommerziell verfügbar. Insbesondere eignen sich Kurzpulslaser, die Laserpulse mit Pulsdauern im Bereich von 100 bis 300 fs erzeugen. Somit eignen sich beispielsweise kommerzielle, mit einem Verstärker ausgerüstete Titan-Saphirlasersysteme (Ti:Saphirlasersysteme), die im Wellenlängenbereich von 800 nm arbeiten.

Obwohl prinzipiell auch abbildende Verfahren nutzbar sind, ist die benötigte Impulsenergie bei einem abtastenden oder abrasternden Verfahren geringer. Bei einer Ausführungsform wird die Strukturierung daher über ein lateral abrasterndes bzw. abtastendes Verfahren vorgenommen. Hierfür ist vorgesehen, dass mit der Strahlführungseinrichtung und/oder der Halterung eine Abtasteinrichtung gekoppelt ist, über die eine Auftreffposition der Kurzpulslaserstrahlung auf die Oberfläche des Gegenstands gesteuert veränderbar ist, so dass die Oberfläche mit der Kurzpulslaserstrahlung gesteuert abrasterbar ist. Der Gegenstand und die Kurzpulslaserstrahlung werden somit relativ zueinander bewegt, so dass ein Auftreffpunkt der Kurzpulslaserstrahlung ein zu strukturierendes Gebiet der Oberfläche abtastet. Die Abtasteinrichtung kann entweder die Kurzpulslaserstrahlung relativ zu einer ortsfesten Oberfläche des Gegenstands bewegen oder den Gegenstand relativ zur ortsfesten Laserstrahlung bewegen. Es sind auch Ausführungsformen denkbar, bei denen eine Kombination dieser beiden Möglichkeiten realisiert ist. Wird die Kurzpulslaserstrahlung hinsichtlich ihrer Lage im Raum variiert, so kann die Abtasteinrichtung in die Strahlführungseinrichtung integriert sein, beispielsweise ansteuerbare optische Strahlführungseinrichtungen, wie Spiegel, Gitter etc., umfassen.

Vorzugsweise werden zumindest Gebiete der zu strukturierenden Oberfläche mäanderartig entlang paralleler Linien abgetastet bzw. abgerastert. Als besonders vorteilhaft hat es sich erwiesen, ein Strahlprofil der Kurzpulslaserstrahlung an die Abtastbewegung anzupassen. Wird eine Abtastung bzw. Abrasterung mäanderartig entlang paralleler Linien ausgeführt, so ist es besonders vorteilhaft, wenn das Strahlprofil möglichst homogen, beispielsweise rechteckartig, zylinderförmig (englisch top-hat-artig) ausgestaltet wird. Hierfür können refraktive oder diffraktive Strahlformungselemente eingesetzt werden, die beispielsweise diffraktive optische Elemente (DOE diffractive optical element) oder refraktive Elemente umfassen.

Die lokale Strukturierungstiefe wird bei einer bevorzugten Ausführungsform in Abhängigkeit von einer effektiven Impulsanzahl N gesteuert, wobei die effektive Impulsanzahl gegeben ist durch:

$$N = \frac{R}{\Delta z \cdot v} \quad A_{Kurzpulsstrahl} ,$$

wobei R die Repetitionsrate der Einzelpulse in der Kurzpulslaserstrahlung ist, $\Delta z$ einen Abstand benachbarter Linien angibt, v eine Geschwindigkeit der Relativbewegung der Kurzpulslaserstrahlung entlang der Linie relativ zu der Oberfläche und $A_{Kurzpulsstrahl}$ eine Fläche der Kurzpulslaserstrahlung in der Taille angibt. Dies bedeutet, dass die Strukturierungstiefe d, welche ein Maß für die Kompression angibt, von der lokal eingebrachten Impulsanzahl kurzer Laserpulse abhängig ist.

Bei einer bevorzugten Ausführungsform wird die Strukturierungstiefe d, d.h. die Änderung der Höhe der Oberfläche, gemäß der folgenden Formel gesteuert: $d = k \cdot N^c$, wobei N die effektive Impulsanzahl, k eine von dem Material des Gegenstands abhängige Proportionalitätskonstante ist und c eine Konstante mit einem Wert im Bereich zwischen 0,45 und 0,55 ist. Abhängig von der ermittelten lokalen Höhe kann somit die Strukturierungstiefe gezielt so gewählt werden, dass diese angepasst geändert wird, um die ermittelten Höhenschwankungen zu kompensieren und so einen lateral ausgedehnten ebenen Gegenstand, d.h. eine Oberfläche mit einer gewünschten Rauheit unterhalb einer Toleranzschwelle, zu erzeugen. Die zu strukturierende Oberfläche ist hierfür vorzugsweise interferometrisch vermessen bzw. wird interferometrisch vermessen, um Höhenschwankungen der Oberfläche entlang der großen lateralen Ausdehnung zu erfassen und/oder anzugeben.

Die Strukturierungstiefe d wird angepasst an die Höhenschwankung gesteuert, um die Rauheit der Oberfläche in der Größenordnung der lokalen Ebenheit vor der Strukturierung über eine größere laterale Ausdehnung zu erzeugen. Die Oberfläche des Gegenstands wird vorzugsweise vor der Strukturierung mechanisch poliert und hierbei eine lokale Rauigkeit in einer Größenordnung von 1 nm oder darunter erreicht.

Bei einer Ausführungsform werden die Ermittlung der Höhenschwankungen über eine interferometrische Vermessung und die Strukturierung über die Einstrahlung von Kurzpulslaserstrahlung iterativ abwechselnd ausgeführt, bis über eine laterale Ausdehnung der Oberfläche eine gewünschte Rauheit erreicht ist. Vorteilhaft ist, dass zwischen der interferometrischen Vermessung und der Strukturierung keine Evakuierung der Umgebung der Oberfläche notwendig ist. Bei geeigneter Ausgestaltung der Vorrichtung wird der Gegenstand mit der Halterung zu einer benachbart angeordneten interferometrischen Messstation bewegt. Andere Ausführungsformen sehen vor, dass die interferometrische Vermessung im Wesentlichen zeitgleich oder zeitgleich mit der Strukturierung ausgeführt wird. Im Wesentlichen zeitgleich soll hierbei bedeuten, dass die interferometrische Höhenbestimmung der Oberfläche während der Strukturierung jedoch an einem anderen Ort ausgeführt wird, der von dem Auftreffpunkt der zur Strukturierung verwendeten Kurzpulslaserstrahlung beabstandet ist.

Das Verfahren kann somit zum Herstellen ausgedehnter Oberflächen mit geringer Rauheit verwendet werden.

Die Erfindung wird nachfolgend anhand eines bevorzugten Ausführungsbeispiels unter Bezugnahme auf eine Zeichnung näher erläutert. Hierbei zeigen:

Fig. 1          eine schematische Darstellung einer Vorrichtung zur Nanostrukturierung von Oberflächen;

Fig. 2          eine schematische Darstellung zur Veranschaulichung des Abrasterns bzw. Abtastens einer Oberfläche;

Fig. 3a, 3b     schematische Darstellungen zur Veranschaulichung einer Oberflächenstrukturierung an einer Zeroduroberfläche (3a) und einem ULE-Glas (3b);

Fig. 4a, 4b     schematische Darstellungen, die eine Strukturierungstiefe in Abhängigkeit von einer Impulsanzahl für Zerodur (4a) und ULE-Glas (4b) für unterschiedliche Laserwellenlängen zeigen;

Fig. 5          eine schematische Darstellung der Strukturierungstiefe, aufgetragen gegen eine Pulsdauer für unterschiedliche Gesamtpulsanzahlen; und

Fig. 6          eine grafische Darstellung zur Veranschaulichung einer maximal erreichbaren Strukturierungstiefe in Abhängigkeit von der Impulsanzahl.

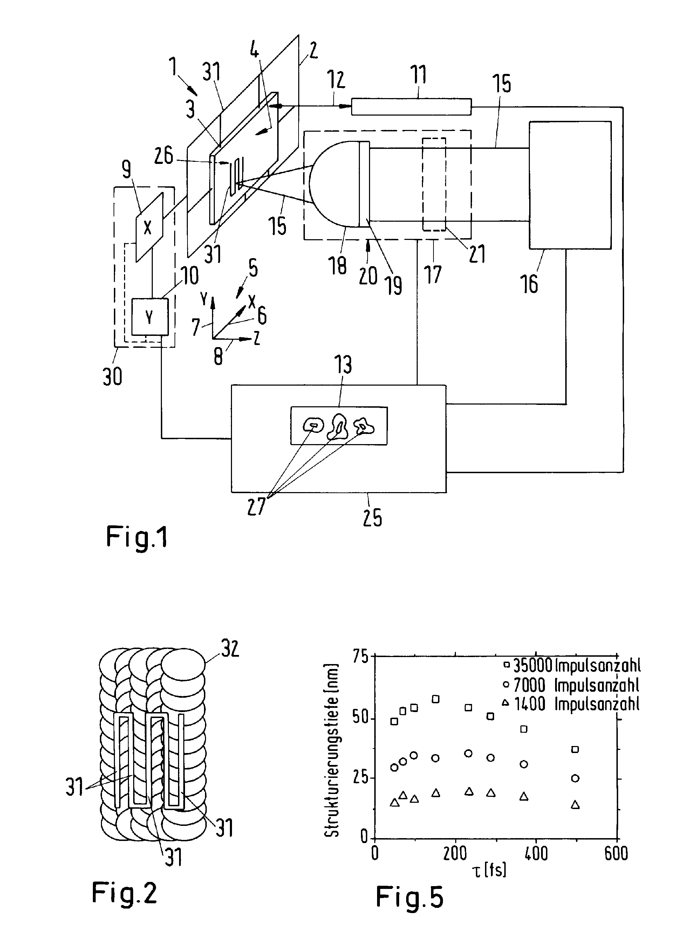

In Fig. 1 ist schematisch eine Vorrichtung zur Nanostrukturierung von Oberflächen 1 dargestellt. In einer Halterung 2 ist ein Gegenstand 3 angeordnet, dessen Oberfläche 4 nanostrukturiert werden soll. Bei dem Gegenstand 3 handelt es sich um einen Gegenstand, der aus einem amorphen Material besteht oder zumindest amorphes Material umfasst. Für eine Strukturierung geeignete Materialien sind beispielsweise Zerodur oder Gläser, beispielsweise ULE-Glas (englisch: ultra low expansion-Glas), also Glas, welches einen sehr niedrigen thermischen Ausdehnungskoeffizienten aufweist. ULE-Glas weist bei 20°C einen Nulldurchgang für den thermischen Ausdehnungskoeffizienten auf.

Um die Oberfläche 4 mit einer geringen Rauheit über eine große laterale Ausdehnung im Bereich mehrerer Millimeter oder sogar mehrerer Zentimeter oder Dezimeter herstellen zu können, wird die Oberfläche 4 zunächst mit einem mechanischen Polierverfahren behandelt. Hierdurch erhält die Oberfläche 4 des Gegenstands 3 eine Rauheit, die lokal in der Größenordnung von 1 nm oder leicht darunter liegt. Über die gesamte laterale Ausdehnung weist die Oberfläche 4 nach einem solchen mechanischen Polieren immer noch Höhenunterschiede von bis zum 100 nm, in der Regel in der Größenordnung von 30 nm bis 70 nm, auf. Assoziiert man mit der Oberfläche 4 ein Koordinatensystem 5, so liegt die Oberfläche 4 in einer Ebene parallel zu einer Ebene, welche durch eine X-Achse 6 und eine Y-Achse 7 des Koordinatensystems 5 aufgespannt wird. Die Höhe der Oberfläche 4 wird entlang der Z-Achse 8 gemessen. Das mechanische Polieren der Oberfläche 4 kann ausgeführt werden, bevor der Gegenstand 3 in die Halterung 2 eingesetzt wird.

Die Halterung 2 ist mit Aktoren 9, 10 gekoppelt, die die Halterung in X- und Y-Richtung bewegen können, so dass hierüber der Gegenstand 2 bzw. die Oberfläche 4 in der xy-Ebene bzw. parallel zu der xy-Ebene verfahren werden kann.

Um die Höhenunterschiede über die laterale Ausdehnung der Oberfläche 4 des Gegenstands 3 zu ermitteln, wird ein Interferometer 11 verwendet. Hierbei wird ein Abtaststrahl 12 über die Oberfläche 4 des Gegenstands 3 bewegt, so dass der Abtaststrahl 12 des Interferometers 11 die Oberfläche 4 abtastet. Die Relativbewegung zwischen dem Abtaststrahl 12 und dem Gegenstand 3 wird vorzugsweise über die Aktoren 9, 10 ausgeführt, die die Halterung 2 und hiermit auch den Gegenstand 3 in der xy-Ebene bewegen. Hierüber können die Höhen der Oberfläche 4 lokal über die gesamte Oberfläche 4 ermittelt werden und so eine Höhenkarte 13 erzeugt werden. Hieraus ergeben sich die Höhenschwankungen auf der Oberfläche 4 des Gegenstands 3.

Um die Oberfläche 4 im Nanometerbereich zu strukturieren, wird diese mit Kurzpulslaserstrahlung 15 beaufschlagt, die in einem Kurzpulslaser 16 erzeugt wird. Als Kurzpulslaser 16 kommen gewöhnliche kommerziell verfügbare Laser, beispielsweise Ti:Saphirlaser, mit einem Verstärker in Betracht. Die aus dem Laser 16 austretende Kurzpulslaserstrahlung 15 wird über eine Strahlführungseinrichtung 17 auf die Oberfläche 4 des Gegenstands 3 geführt. Die Strahlführungseinrichtung 17 umfasst beispielsweise eine plankonvexe Linse 18 und ein hiermit gekoppeltes diffraktives optisches Element 19 (DOE Diffractive Optical Element) als Strahlformungseinrichtung 20, welche ein Strahlprofil der Kurzpulslaserstrahlung 15 im Bereich der Oberfläche 4 des Gegenstands 3 formt. Bevorzugt wird das Strahlprofil so beeinflusst, dass dieses über eine gesamte Querschnittsfläche $A_{Kurzpulsstrahl}$ homogen ist. Beispielsweise kommen so genannte zylindrische Strahlprofile (Top-hat-Profile) oder auch rechteckige Profile in Betracht. Anstelle eines diffraktiven optischen Elements können auch refraktive Strahlformungselemente verwendet werden. Die Strahlführungseinrichtung 17 umfasst neben der Strahlformungseinrichtung 20 gegebenenfalls weitere optische Elemente 21, wie beispielsweise Spiegel, Gitter oder Ähnliches. Einige von diesen können auch über eine Steuerung 25 ansteuerbar sein können.

Der Kurzpulslaser 16 erzeugt vorzugsweise Laserstrahlung im infraroten Wellenlängenbereich, beispielsweise bei 800 nm. Der Kurzpulslaser kann somit beispielsweise als Ti:Saphirlaser ausgebildet sein. Die einzelnen Laserpulse weisen bevorzugt eine Pulsdauer im Femtosekundenbereich, besonders bevorzugt im Bereich zwischen 100 fs und 300 fs, auf. Der Gegenstand 3 muss in dem Wellenlängenbereich der verwendeten Kurzpulslaserstrahlung 15 transparent sein.

Über die Strahlformungseinrichtung 19 sowie den Kurzpulslaser 16 wird eine Fluenz F so gewählt, dass diese für jeden Einzelpuls unterhalb einer Multischuss-Schwellfluenz $F_{th}$ ist. Besonders bevorzugt wird die Fluenz F im Bereich von 65 % bis 95 % der Multischuss-Schwellfluenz $F_{th}$ gewählt. Diese Multischuss-Schwellfluenz $F_{th}$ gibt die Fluenz F an, ab der bei einer Multischussbeaufschlagung eine Ablation des Materials auftritt. Die Fluenz F wird ferner so gewählt, dass keine Coulombexplosion auftritt.

Durch diese Wahl der Fluenz F, vorzugsweise im Bereich zwischen 65 % und 95 % der Multischuss-Schwellfluenz $F_{th}$, in jedem Fall jedoch kleiner als die Multischuss-Schwellfluenz $F_{th}$, aber doch so hoch, dass nichtlineare Wechselwirkungen ausgelöst werden können, wird erreicht, dass in dem Gegenstand 3 über nichtlineare Prozesse Störstellen erzeugt werden können. Diese führen dazu, dass der Gegenstand 3 komprimiert wird und hierdurch eine Höhe der Oberfläche 4 verändert, d.h. verringert wird. Diese Verringerung wird als Strukturierungstiefe d bezeichnet. In abgeschwächter Form findet eine Kompression ebenfalls auf einer Rückseite 26 des Gegenstands 3 statt. Bei einer Strukturierung einer 2 mm starken Zerodurplatte wurde ein um den Faktor 10 abgeschwächter Effekt auf der Rückseite 26 beobachtet. Um eine einheitliche Rauheit der Oberfläche 4 zu erreichen, werden jene Gebiete 27, welche gemäß der Höhenkarte 13 eine größere Höhe als die niedrigsten Bereiche aufweisen, über die Kurzpulslaserstrahlung 15 nanostrukturiert. Hierfür wird die Halterung 2 und hierüber der Gegenstand 3 sowie die Oberfläche 4 über die Aktoren 9, 10 parallel zur xy-Ebene verfahren. Die Aktoren 9, 10 bilden somit eine Abtasteinrichtung 30. Vorzugsweise wird die Oberfläche 4 entlang paralleler Linien 31 abgetastet bzw. abgerastert, wobei dies insgesamt zumindest lokal vorzugsweise mäanderartig erfolgt. Dies ist schematisch in Fig. 2 dargestellt. Die einzelnen sich überlappenden Auftreffbereiche 32 der Laserpulse sind kreisförmig dargestellt. Die Auftreffbereiche 32 spiegeln einen Strahlquerschnitt der Kurzpulslaserstrahlung 15 wieder.

Die Strukturierungstiefe d ist abhängig von einer effektiven Impulsanzahl N, welche bei einem linearen Abrastern der Oberfläche durch folgende Formel gegeben ist:

$$N = \frac{R}{\Delta z \cdot v} \cdot A_{Kurzpulsstrahl} \, ,$$

wobei R die Repetitionsrate der Einzelpulse angibt, $\Delta z$ einen Abstand der benachbarten Linien 31 und v eine Geschwindigkeit der Relativbewegung der Kurzpulslaserstrahlung 15 zur Oberfläche 4 des Gegenstands 3 in der xy-Ebene, d.h. eine Geschwindigkeit v entlang der Linien 31 angibt und $A_{Kurzpulsstrahl}$ eine Fläche der Kurzpulslaserstrahlung auf der Oberfläche angibt. Als Fläche wird ein Gebiet betrachtet, in dem die Intensität größer als $1/e^2$ der maximalen Intensität der Kurzpulslaserstrahlung ist. Mittels der angegebenen Formel ist es gezielt möglich, durch eine geeignete Wahl der effektiven Impulsanzahl, die eine Position der Oberfläche 4 lokal treffen, deren Strukturierungstiefe im Subnanometerbereich zu kontrollieren. Die Strukturierungstiefe d lässt sich gemäß folgender Formel errechnen:

$$d = k * N^c \, ,$$

wobei N die effektive Impulsanzahl, k eine von dem Material des Gegenstands 3 abhängige Proportionalkonstante ist und c eine Konstante mit einem Wert im Bereich zwischen 0,45 und 0,55 ist.

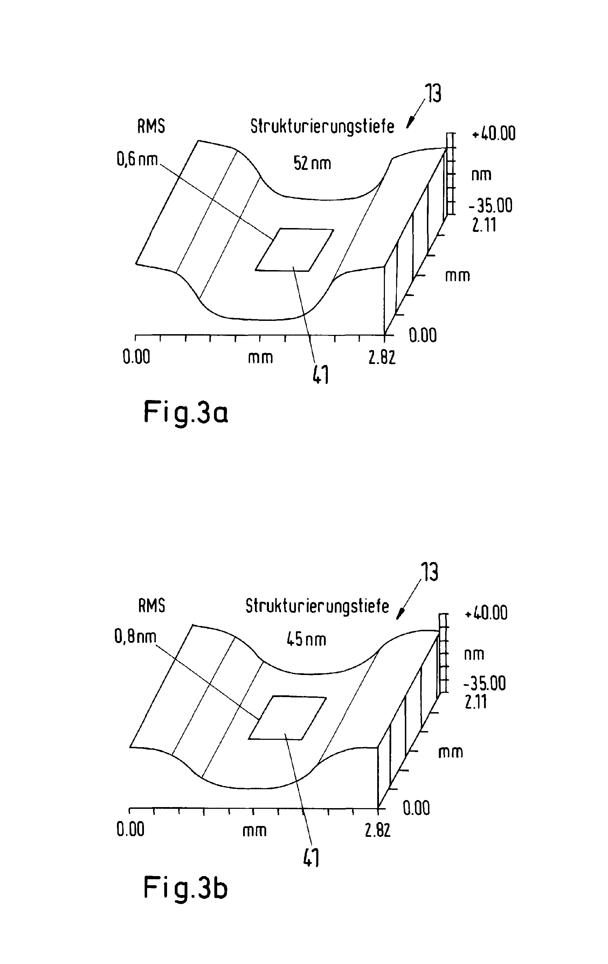

In Figuren 3a und 3b ist jeweils schematisch eine Konturenkarte 13 einer Oberfläche 4 eines Gegenstands 3 dargestellt, der jeweils lokal über Kurzpulslaserstrahlung strukturiert ist. Diese Konturenkarten 13 sind nach der Strukturierung erfasst. In Fig. 3a ist eine Strukturierung von Zerodur bei der Wellenlänge $\lambda = 800$ nm, einem Linienabstand von $\Delta z = 5$ μm und einer Geschwindigkeit v = 4 mm/s mit einer relativen Fluenz $F/F_{th}$ = 0,85 gezeigt. Ingesamt ist die Strukturierung mit einer Strukturierungstiefe d von 52 nm ausgeführt. Eine quadratische Rauheit (mittlere quadratische Abweichung) beträgt 0,6 nm in dem strukturierten Zielbereich 41. In Fig. 3b ist eine entsprechende Strukturierung um 45 nm für ULE-Glas gezeigt, wobei eine Wellenlänge von 800 nm, eine Geschwindigkeit v = 0,05 mm/s und ein Linienabstand von $\Delta z = 70$ μm sowie eine relative Fluenz $F/F_{th}$ = 0,9 verwendet sind. Die erreichte quadratische Rauheit (mittlere quadratische Abweichung) beträgt in diesem Fall 0,8 nm.

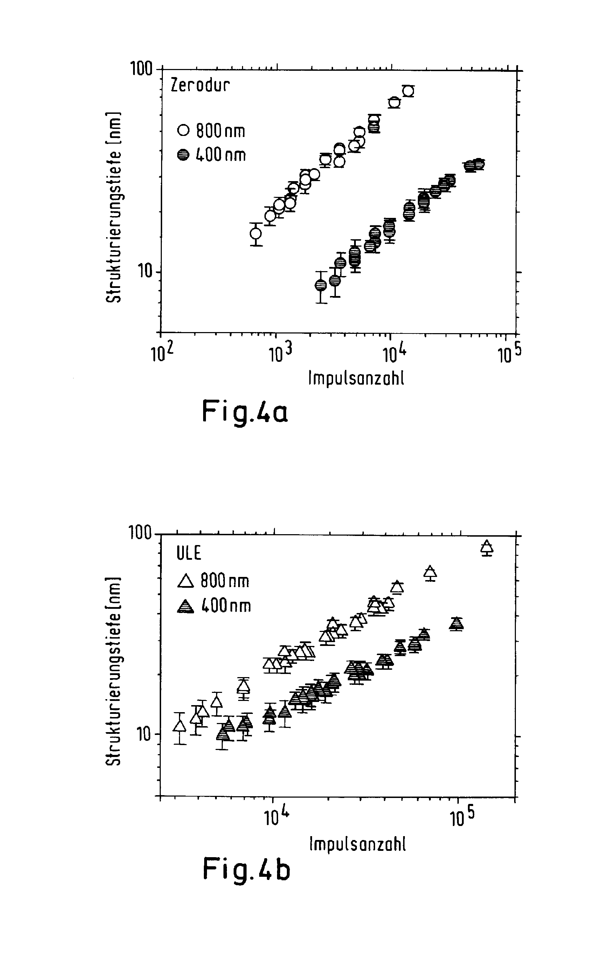

Wie aus Fig. 4a und 4b zu sehen ist, lässt sich die Strukturierungstiefe über die Anzahl der effektiven Impulse N präzise einstellen. Aufgetragen ist dort die Strukturierungstiefe d über der effektiven Impulsanzahl N. In Fig. 4a sind Werte für Zerodur, in Fig. 4b für ULE-Glas angegeben. Gezeigt sind jeweils Messwerte für Kurzpulslaserstrahlung im infraroten einer Wellenlängenbereich bei $\lambda = 800$ nm, leere Kreise bzw. Dreiecke, und im sichtbaren Wellenlängenbereich bei einer Wellenlänge von $\lambda = 400$ nm (blaues Licht), volle Kreise bzw. volle Dreiecke. Es ist sehr gut zu erkennen, dass überraschenderweise im infraroten Wellenlängenbereich eine sehr viel größere Strukturierungstiefe sowie eine bestimmte Strukturierungstiefe bei sehr viel geringeren Impulsanzahlen möglich ist. Durch eine Verwendung von Ultrakurzpulslaserstrahlung im infraroten Wellenlängenbereich lässt sich eine Strukturierung somit sehr viel besser ausführen, d.h. eine Strukturierung größerer Höhenunterschiede ist möglich. Zum anderen wird eine Anzahl der Materialien, die strukturierbar sind, erweitert, da Materialien, die im infraroten Wellenlängenbereich transparent sind, strukturierbar sind. Vorraussetzung ist natürlich weiterhin, dass die Materialien amorph sind oder zumindest einen amorphen Anteil aufweisen.

In Fig. 5 ist auf die Strukturierungstiefe gegenüber einer Einzelpulsdauer jeweils für drei unterschiedliche effektive Impulsanzahlen dargestellt. Zum einen ist erneut zu erkennen, dass die Impulsanzahl die Modifikationstiefe beeinflusst. Von der Einzelpulsdauer ist eine sehr viel geringere Abhängigkeit zu erkennen. Insgesamt ergibt sich jedoch, dass die besten Strukturierungsergebnisse bei Pulsdauern im Bereich von 100 bis etwa 300 fs Pulsdauern erreicht werden.

Untersuchungen haben ergeben, dass es für die einzelnen Materialien in der Regel eine maximale Strukturierungstiefe $d_{max}$ gibt. Dies bedeutet, dass die Strukturierungstiefe d bei sehr großen Impulsanzahlen N in eine Sättigung übergeht. Die Strukturierungstiefe d lässt sich auch abhängig von der maximalen Strukturierungstiefe $d_{max}$ durch folgende empirische Formel angeben:

$$d = d_{max}\left(1 - e^{-b \cdot N^c}\right)$$

Hierbei gibt $d_{max}$ die maximale erreichbare Strukturierungstiefe an, b ist ein Parameter, N ist die oben definierte effektive Impulsanzahl und c ist der bereits oben angegebene Exponent, der Werte im Bereich zwischen 0,45 und 0,55 annehmen kann.

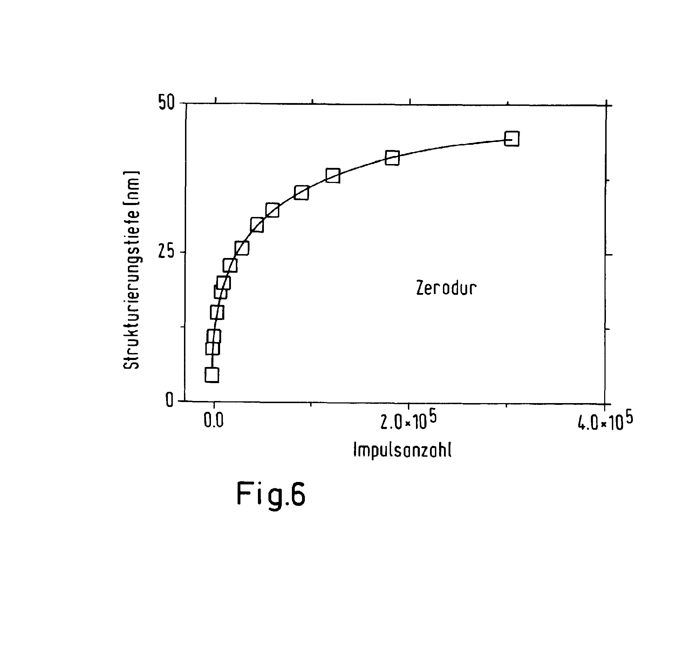

Dieser Zusammenhang ist in Fig. 6 schematisch dargestellt. Dort ist die Strukturierungstiefe gegen die effektive Impulsanzahl aufgetragen.

Es ergibt sich somit, dass die Strukturierungstiefe gezielt eingestellt werden kann, indem ein Linienabstand, eine Relativbewegung entlang der Linien sowie eine Fluenz und eine Pulsdauer geeignet gewählt werden. Bei der oben beschriebenen Ausführungsform wird die Relativbewegung durch eine Verschiebung des Gegenstands 3 parallel zur xy-Ebene erreicht. Andere Ausführungsformen können vorsehen, dass die Kurzpulslaserstrahlung 15 relativ zu einem ortsfesten Gegenstand 3 bewegt wird. Wieder andere Ausführungsformen können eine Kombination vorsehen, wobei sowohl der Gegenstand als auch Kurzpulslaserstrahlung relativ zu einem ortsfesten Koordinatensystem bewegt werden.

Ein besonderer Vorteil in der Verwendung des beschriebenen Verfahrens bzw. der beschriebenen Vorrichtung liegt darin, dass der Gegenstand mit der zu strukturierenden Oberfläche 4 zur Strukturierung nicht ins Vakuum verbracht werden muss. Sowohl die Strukturierung als auch die Vermessung der Höhenunterschiede kann bei atmosphärischen Normalbedingungen ausgeführt werden. Diese kann zum einen vorher, und zur Kontrolle nachträglich ausgeführt werden, jedoch auch während der Strukturierung am selben oder einem benachbart zu der Strukturierung befindlichen Ort vorgenommen werden.

Wie sich aus der Formel zur Berechnung der effektiven Impulsanzahl ergibt, kann die Strukturierungstiefe bei einigen Ausführungsformen auch über eine Variation der Repetitionsrate vorgenommen werden.

Die Steuerung 25 ist vorzugweise so ausgelegt, dass diese den Kurzpulslaser 16, die Strahlführungseinrichtung 17 und/oder die Abtasteinrichtung 30 sowie vorzugsweise das Interferometer 11 steuert. Die Aktoren 9, 10 werden über die Abtasteinrichtung 30 oder direkt angesteuert. Das Ansteuern der Strahlführungseinrichtung 17 umfasst das Ansteuern sämtlicher Komponenten, die ein Strahlprofil und oder eine Führung der Kurzpulslaserstrahlung beeinflussen. Unter die Steuerung des Kurzpulslasers 16 wird auch das Ansteuern von Verstärkerkomponenten usw. angesehen.

Es versteht sich für den Fachmann, dass lediglich beispielhafte Ausführungen der Erfindung beschrieben sind.

Bezugszeichenliste

1  Vorrichtung zur Nanostrukturierung

2  Halterung

3  Gegenstand

4  Oberfläche

5  Koordinatensystem

| | |
|---|---|
| 6 | x-Achse |
| 7 | y-Achse |
| 8 | z-Achse |
| 9 | Aktor |
| 10 | Aktor |
| 11 | Interferometer |
| 12 | Abtaststrahl |
| 13 | Höhenkarte |
| 15 | Kurzpulslaserstrahlung |
| 16 | Kurzpulslaser |
| 17 | Strahlführungseinrichtung |
| 18 | plankonvexer Spiegel |
| 19 | diffraktives optisches Element |
| 20 | Strahlformungseinrichtung |
| 21 | weitere Elemente |
| 25 | Steuerung |
| 30 | Abtasteinrichtung |
| 26 | Rückseite |
| 27 | Gebiete |
| 31 | Linien |
| 32 | Auftreffbereiche |
| 41 | Zielbereich |

**Patentansprüche**

1. Verfahren zum Herstellen nanostrukturierter Oberflächen (4), umfassend die Schritte:

   Bereitstellen eines Gegenstands (3), welcher eine zu strukturierende Oberfläche (4) aufweist;
   Erzeugen von Kurzpulslaserstrahlung (15) mit Laserpulsen, deren Pulsdauern im Subnanosekundenbereich liegen, vorzugsweise kürzer als 10 ps sind;
   Richten der Kurzpulslaserstrahlung (15) auf die zu strukturierende Oberfläche (4) des Gegenstands (3),
so dass eine Fluenz F eines jeden Einzelpulses der Kurzpulslaserstrahlung (15) auf der Oberfläche (4) kleiner als eine Multischuss-Schwellfluenz $F_{th}$ für eine Multischuss-Laserablation ist und die Kurzpulslaserstrahlung (15) über nicht lineare Effekte Störstellen in dem Gegenstand (3) erzeugt, die zu einer lokalen Kompression des Gegenstands (3) und der Strukturierung der Oberfläche (4) führen.

2. Verfahren nach Anspruch 1, **dadurch gekennzeichnet, dass** eine Fluenz F im Bereich von 50% bis 99% der Multischuss-Schwellfluenz $F_{th}$, bevorzugter im Bereich von 65% bis 95% der Multischuss-Schwellfluenz $F_{th}$, gewählt wird.

3. Verfahren nach Anspruch 1 oder 2, **dadurch gekennzeichnet, dass** die Fluenz F so gewählt wird, dass diese unterhalb einer Schwelle liegt, ab der eine Coulombexplosion auftreten kann.

4. Verfahren nach einem der vorangehenden Ansprüche, **dadurch gekennzeichnet, dass** die Kurzpulslaserstrahlung (15) mit einer Wellenlänge im infraroten Wellenlängenbereich erzeugt wird.

5. Verfahren nach einem der vorangehenden Ansprüche, **dadurch gekennzeichnet, dass** der Gegenstand und die Kurzpulslaserstrahlung (15) relativ zueinander bewegt werden, so dass ein Auftreffpunkt der Kurzpulslaserstrahlung (15) ein zu strukturierendes Gebiet der Oberfläche (4) abrastert.

6. Verfahren nach einem der vorangehenden Ansprüche, **dadurch gekennzeichnet, dass** das Gebiet mäanderartig entlang paralleler Linien (31) abgerastert wird.

7. Verfahren nach einem der vorangehenden Ansprüche, **dadurch gekennzeichnet, dass** eine Strukturierungstiefe d in Abhängigkeit von einer effektiven Impulsanzahl N gesteuert wird, wobei die effektive Impulsanzahl gegeben ist durch:

$$N = \frac{R}{\Delta z \cdot v} \cdot A_{\text{Kurzpulsstrahl}}, \text{ wobei R eine}$$

Repetitionsrate der Einzelpulse ist, $\Delta z$ einen Abstand benachbarter Linien angibt, v eine Geschwindigkeit der Relativbewegung der Kurzpulslaserstrahlung (15) entlang der Linien (31) und $A_{\text{Kurzpulsstrahl}}$ eine Fläche der Kurzpulslaserstrahlung (15) in der Taille angibt.

8. Verfahren nach einem der vorangehenden Ansprüche, **dadurch gekennzeichnet, dass** die Strukturierungstiefe d gemäß der folgenden Formel gesteuert wird:

d = k · N^c, wobei N die effektive Impulsanzahl, k eine von dem Material des Gegenstands (3) abhängige Proportionalitätskonstante ist und c eine Konstante mit einem Wert im Bereich zwischen 0,45 und 0,55 ist.

9. Verfahren nach einem der vorangehenden Ansprüche, **dadurch gekennzeichnet, dass** die Kurzpulslaserstrahlung (15) mit einem über einen Strahlquerschnitt nahezu homogenen Strahlprofil erzeugt wird oder das Strahlprofil entsprechend geformt wird.

10. Verfahren nach einem der vorangehenden Ansprüche, **dadurch gekennzeichnet, dass** die zu strukturierende Oberfläche (4) des Gegenstands (3) interferometrisch vermessen wird oder ist, um Höhenschwankungen der Oberfläche (4) zu erfassen und/oder anzugeben.

11. Verfahren nach einem der vorangehenden Ansprüche, **dadurch gekennzeichnet, dass** die Strukturierungstiefe d angepasst an die Höhenschwankung gesteuert wird, um eine großflächige Rauheit der Oberfläche (4) in der Größenordnung der lokalen Rauheit vor der Strukturierung zu erzeugen.

12. Vorrichtung (1) zum Herstellen nanostrukturierter Oberflächen (4) umfassend:

einen Kurzpulslaser (16) zum Erzeugen von Kurzpulslaserstrahlung (15) mit Laserpulsen, deren Pulsdauern im Subnanosekundenbereich liegen, vorzugsweise kürzer als 10 ps sind; eine Halterung zum Aufnehmen eines Gegenstands (3), dessen Oberfläche (4) strukturiert werden soll, eine Strahlführungseinrichtung (17) zum Führen der Kurzpulslaserstrahlung (15) auf die zu strukturierende Oberfläche (4) des Gegenstands (3); wobei der Kurzpulslaser (16) und die Strahlführungseinrichtung (17) so ausgebildet sind, dass eine Fluenz F eines jeden Einzelpulses der Kurzpulslaserstrahlung (15) auf der Oberfläche (4) kleiner als eine Multischuss-Schwellfluenz $F_{th}$ für eine Multischuss-Laserablation ist, jedoch so hoch ist, dass in dem Gegenstand (3) über nicht lineare Effekte Störstellen erzeugbar sind, die zu einer Kompression des Gegenstands (3) und der Strukturierung der Oberfläche (4) führen.

13. Vorrichtung (1) nach Anspruch 12, **dadurch gekennzeichnet, dass** mit der Strahlführungseinrichtung (17) und/oder der Halterung (2) eine Abtasteinrichtung (30) gekoppelt ist, über die eine Auftreffposition der Kurpulslaserstrahlung (15) auf die Oberfläche (4) des Gegenstands (3) gesteuert veränderbar ist, so dass die Oberfläche (4) mit der Kurzpulslaserstrahlung (15) gesteuert abrasterbar ist.

14. Vorrichtung (1) nach Anspruch 12 oder 13, **dadurch gekennzeichnet, dass** der Kurzpulslaser (16) und die Strahlführungseinrichtung (17) so ausgebildet sind, dass eine Fluenz F kleiner als eine Schwelle ist, ab der eine Coulombexplosion auftreten kann.

Fig.1

Fig.2

Fig.5

**Fig.3a**

**Fig.3b**

Fig.4a

Fig.4b

Fig.6